# FASCICULE DE BREVET EUROPEEN

(11) **EP 1 756 920 B1**
(45) Date de publication et mention de la délivrance du brevet: **24.11.2010**
(21) Numéro de dépôt: 05757123.4
(22) Date de dépôt: 14.04.2005
(51) Int. Cl.: H01S 3/13, H04J 14/02

(54) **SOURCE LASER ACCORDABLE A ADRESSAGE OPTIQUE DE LA LONGUEUR D'ONDE**
ABSTIMMBARE LASERQUELLE MIT OPTISCHER WELLENLÄNGENADRESSIERUNG
TUNABLE LASER SOURCE WITH OPTICAL WAVELENGTH ADDRESSING

(30) Priorité: 14.04.2004 FR 0403890
(43) Date de publication de la demande: 28.02.2007
(73) Titulaire: CENTRE NATIONAL DE LA RECHERCHE SCIENTIFIQUE (CNRS), 75794 Paris Cedex 16 (FR); Universite Paris-Sud, 91400 Orsay (FR)
(72) Inventeur: DUBREUIL, Nicolas, F-91940 Les Ulis (FR); PAULIAT, Gilles, F-91940 Les Ulis (FR); ROOSEN, Gérald, F-78720 La Celle les Bordes (FR)
(74) Mandataire: Novagraaf Technologies
(86) Numéro de dépôt international: PCT/FR2005/000906
(87) Numéro de publication internationale: WO 2005/104310

(56) Documents cités:
- EP-A- 0 829 935
- WO-A-00/25396
- WO-A-02/31934
- US-A- 5 097 478
- GODARD A ET AL: "Relaxation of the alignment tolerances of a 1.55-[mu]m extended-cavity semiconductor laser by use of an intracavity photorefractive filter" OPTICS LETTERS OPT. SOC. AMERICA USA, vol. 26, no. 24, 15 décembre 2001 (2001-12-15), pages 1955-1957, XP002300181 ISSN: 0146-9592
- LYUKSYUTOV S F ET AL: "PULSED DYE LASER WITH AN INTRACAVITY NONLINEAR MIRROR UTILIZING A PHOTOREFRACTIVE CRYSTAL" SOVIET JOURNAL OF QUANTUM ELECTRONICS, AMERICAN INSTITUTE OF PHYSICS. WOODBURY, NY, US, vol. 20, no. 3, 1 mars 1990 (1990-03-01), pages 237-238, XP000141719
- ROOSEN G ET AL: "Self-organization of laser cavities using dynamic holograms" OPTICAL MATERIALS, ELSEVIER SCIENCE PUBLISHERS B.V. AMSTERDAM, NL, vol. 23, no. 1-2, juillet 2003 (2003-07), pages 289-293, XP004430676 ISSN: 0925-3467
- ROOSEN G ET AL: "Adaptive shaping and filtering of laser beams using photorefractive elements" CONFERENCE ON LASERS AND ELECTRO-OPTICS. (CLEO 2001). TECHNICAL DIGEST. POSTCONFERENCE EDITION. BALTIMORE, MD, MAY 6-11, 2001, TRENDS IN OPTICS AND PHOTONICS. (TOPS), US, WASHINGTON, WA : OSA, US, vol. VOL. 56, 6 mai 2001 (2001-05-06), pages 341-341, XP010559917 ISBN: 1-55752-662-1
- WHITTEN W B ET AL: "MODE SELECTION IN A CONTINUOUS-WAVE DYE LASER WITH AN INTRACAVITY PHOTOREFRACTIVE ELEMENT" OPTICS LETTERS, OPTICAL SOCIETY OF AMERICA, WASHINGTON, US, vol. 12, no. 2, 1 février 1987 (1987-02-01), pages 117-119, XP000710524 ISSN: 0146-9592 cité dans la demande
- LYUKSYUTOV S F ET AL: "SPECTRAL EQUALIZATION AND AUTOSWEEPING EFFECTS IN A PULSED DYE LASER WITH AN INTRACAVITY PHOTOREFRACTIVE ELEMENT" APPLIED OPTICS, OPTICAL SOCIETY OF AMERICA,WASHINGTON, US, vol. 31, no. 9, 20 mars 1992 (1992-03-20), pages 1217-1220, XP000262548 ISSN: 0003-6935 cité dans la demande
- HUOT N ET AL: "LASER MODE MANIPULATION BY INTRACAVITY DYNAMIC HOLOGRAPHY: APPLICATION TO MODE SELECTION" APPLIED PHYSICS B: LASERS AND OPTICS, SPRINGER INTERNATIONAL, BERLIN, DE, vol. B69, no. 2, août 1999 (1999-08), pages 155-157, XP000835085 ISSN: 0946-2171 cité dans la demande
- MAERTEN S ET AL: "Laser diode made single-mode by a self-adaptive photorefractive filter" OPTICS COMMUNICATIONS, NORTH-HOLLAND PUBLISHING CO. AMSTERDAM, NL, vol. 208, no. 1-3, 1 juillet 2002 (2002-07-01), pages 183-189, XP004369127 ISSN: 0030-4018 cité dans la demande
- MOGENSEN F ET AL: "LOCKING CONDITIONS AND STABILITY PROPERTIES FOR A SEMICONDUCTOR LASER WITH EXTERNAL LIGHT INJECTION" IEEE JOURNAL OF QUANTUM ELECTRONICS, IEEE INC. NEW YORK, US, vol. QE-21, no. 7, 1 juillet 1985 (1985-07-01), pages 784-793, XP000705704 ISSN: 0018-9197

## Description

La présente invention se rapporte au domaine de l'optique.

La présente invention se rapporte plus particulièrement à une source laser accordable à adressage optique de la longueur d'onde.

La présente invention se rapporte à un (et un ensemble de) laser(s), qualifié(s) de "laser esclave", dont la cavité intègre un milieu holographique dynamique et dont la longueur d'onde est fixée par injection optique dans sa cavité d'un faisceau issu d'un second laser, qualifié de "laser maître". En régime d'injection, le laser esclave oscille sur un mode dont la longueur d'onde est proche voire identique à celle du laser maître. Il s'enregistre alors un hologramme dans le milieu holographique dynamique. Cet hologramme agit comme un filtre spectral dont le minimum de perte correspond au mode qui a enregistré l'hologramme, c'est-à-dire au mode qui oscille. Le mode qui oscille est donc stabilisé par l'hologramme. Après coupure du faisceau issu du laser maître, les pertes induites par l'hologramme maintiennent ce mode au-dessus du seuil d'oscillation et les autres en dessous de ce seuil : seul le mode sélectionné par l'injection oscille. En retour, l'oscillation de ce mode réinscrit en permanence l'hologramme qui ne peut donc pas s'effacer. L'oscillation sur le mode, et donc la longueur d'onde sélectionnée, est donc auto-entretenue après extinction du laser maître. Ceci n'est pas le cas dans les expériences plus classiques d'injection d'un laser maître vers un laser esclave qui ne comporte pas de milieu holographique, la perturbation du fonctionnement du laser esclave n'est effective que pendant la durée de l'injection. Dès qu'il n'est plus soumis à l'injection du faisceau issu du laser maître, le laser esclave retrouve ses conditions d'oscillation propres et ne conserve pas son état de fonctionnement en régime d'injection.

L'art antérieur connaît déjà, par la demande de brevet européen EP 1 125 347 (Centre National de la Recherche Scientifique), des filtres auto-adaptés pour l'affinement de l'émission laser. L'invention objet de cette demande de brevet européen concerne une source de rayonnement lumineux de type laser comportant une cavité résonante et un milieu amplificateur placée dans la cavité résonante caractérisée en ce qu'un matériau photosensible dynamique est placé dans la cavité résonante pour former un filtre spectral et/ou spatial auto-adaptable.

L'art antérieur connaît également, par la demande de brevet européen EP 1 327 289 (Photonetics), une source laser monomode continûment accordable en longueur d'onde avec une cavité externe comportant :
- une cavité résonante possédant une face plane réfléchissante, des moyens d'extraction d'une partie du flux lumineux et un dispositif dispersif rétro-réfléchissant ;
- au moins un guide d'onde amplificateur placé à l'intérieur de la cavité résonante ;
- des moyens de contrôle du dispositif dispersif rétro-réfléchissant lui assurant l'accordabilité continue, caractérisée en ce qu'elle comporte un composant photoréfractif placé dans la cavité, sensible à la longueur d'onde de la source laser, au sein duquel est formé un réseau de Bragg.

L'art antérieur connaît égalment, par la demande de brevet européen EP 0 829 935 (Kokusai Denshin Kabushiki Kaisha), un dispositif comprenant un laser dont la longeur d'onde est fixée par injection optique dans sa cavité d'un faisceau de référence, et une unité destinée à entretenir la longeur d'onde à celle selectionée par le faisceau de référence après l'extinction de celui-ci.

On connaît également dans l'état de la technique, par la demande de brevet européen EP 0 375 021 (Philips), un laser à diode semi-conductrice accordable à réflexion répartie et un procédé de fabrication d'un tel laser à diode semi-conductrice. L'invention décrite dans ce document se rapporte plus particulièrement à un laser à diode semi-conductrice accordable à réflexion répartie comportant un corps semi-conducteur dans lequel une première couche de guidage de rayonnement est superposée à une première couche passive dans laquelle, entre deux surfaces s'étendant à peu près perpendiculairement auxdites couches, est formée une cavité résonante en forme de bande, dans laquelle sont juxtaposées une première section pourvue d'une première alimentation en courant et une région active associée présentant une jonction P-N qui, à une intensité de courant suffisamment élevée, engendre dans le sens direct un rayonnement électro-magnétique cohérent, ladite région active se situant dans le profil d'amplification de la couche de guidage de rayonnement et étant limitée latéralement par une seule couche de côtés contigus à d'autres sections, une deuxième section pourvue d'une deuxième alimentation en courant permettant de faire varier l'indice de réfraction d'une partie de la couche de guidage de rayonnement située dans cette section, et une troisième section pourvue d'une troisième alimentation en courant, la partie de la cavité résonante située dans cette section comportant une variation périodique de l'indice de réfraction dans le sens longitudinal, laser à diode dans lequel la première couche de guidage de rayonnement est située sur toute la longueur de la cavité résonante, caractérisé en ce que le laser à diode semi-conductrice comporte des moyens par lesquels l'intensité relative de la partie du rayonnement engendré dans la première section, réfléchie à l'endroit de la jonction située entre la première et la deuxième section est rendue faible par rapport à l'intensité du rayonnement retournant de la deuxième section à la jonction.

On connaît également, dans l'art antérieur, les publications scientifiques suivantes :
- K. Liu and M.G. Littman, "Novel geometry for single-mode scanning of tunable lasers'', Opt. Lett. Vol. 6, pp.117-118, 1981
- F. Favre and D. Le Guen, "82 nm of continuous tunability for an external cavity semi-conductor laser ", Electron. Lett. Vol.27, pp. 183-184, 1991.
- L.A Coldren, ''Monolithic Tunable Diode Laser ", IEEE Journal on Selected Topics in Quantum Electron. , vol.6, pp. 988-999, 2000.
- N. Huot, J.-M. Jonathan, G. Pauliat, P. Georges, A. Brun, G. Roosen, Appl. Phys. B 69, pp. 155, 1999
- S. Maerten, N. Dubreuil, G. Pauliat, G. Roosen, D. Rytz, T. Salva, "Laser diode made single-mode by a self-adaptive photorefractive filter", Optics Communications 208, pp. 183-189, 2002
- S.F. Lyuksyutov and O.I. Yuschuk, "Spectral equalization and autosweeping effects in a pulsed dye laser with an intracavity photorefractive element", Applied Optics, vol. 31, pp. 1217-1220, 1992.
- F. Mogensen, H. Olesen and G. Jacobsen, IEEE J. Quantum Electron. QE-21, pp. 78, 1985.
- Petitbon, P. Gallion, G. Debarge, C. Chabran, IEEE J. Quantum Electron. QE-24, pp. 148, 1988.

L'invention se situe dans le contexte du contrôle du spectre émis par des lasers et plus particulièrement de celui des lasers accordables en longueurs d'onde. Nous avons recensé les différentes méthodes utilisées suivant trois catégories. La première fait référence à l'utilisation et l'insertion dans la cavité du laser de filtres fréquentiels qualifiés de « statiques » (leur réponse en fréquence est fixe). La deuxième catégorie est celle qui utilise des filtres qualifiés de « dynamiques » (leur réponse en fréquence n'est pas figée). Enfin la dernière décrit les méthodes d'injection optique d'un faisceau externe cohérent (issu d'un autre laser) dans la cavité du laser à contrôler.

Pour chacune des catégories, nous avons répertorié les limites technologiques des procédés décrits dans le cadre du besoin suivant : disposer de N sources laser accordables en longueurs d'onde (par exemple dans le cadre des systèmes de communications optiques). On se place dans une application où il est nécessaire de devoir disposer de plusieurs sources laser accordables en longueurs d'onde fonctionnant simultanément et pouvant être reconfigurées (programmées) indépendamment les unes des autres.
1) Une première méthode pour le contrôle du spectre d'émission d'un laser consiste à insérer dans la cavité du laser des filtres optiques sélectifs en fréquence. Il existe une première classe de filtres qualifiés de "statiques", comme par exemple les filtres interférentiels, les réseaux de diffraction, les étalons de Fabry-Perot... Une fois le filtre inséré dans la cavité, il induit des différences de pertes fixes entre les modes du laser et peut conduire à l'émission laser selon un seul mode : le laser est alors qualifié de monomode (ou monochromatique). La longueur d'onde d'émission du laser est celle pour laquelle le filtre induit un minimum de pertes. Il est possible de faire varier cette longueur d'onde en agissant sur le filtre. Dans le cas de l'utilisation d'un réseau de diffraction, la longueur d'onde d'émission est fixée par l'angle d'incidence du faisceau sur le réseau. En faisant varier cet angle, on réalise une source accordable en longueur d'onde dont les applications sont nombreuses. Dans le domaine des communications optiques, ces sources à diode laser, de type cavité étendue, ont une accordabilité continue sur une plage de 100 nm. Ces sources, relativement coûteuses, sont largement utilisées pour la caractérisation de composants optiques passifs et actifs. Elles ne s'insèrent pas dans les liaisons de transmission. En revanche, il existe depuis plusieurs années des sources à diode laser accordables compactes, fabriquées sur la base de l'intégration sur un même chip de toutes les fonctionnalités nécessaires. Ces sources sont des diodes laser de type DBR ("Distributed Bragg Reflector") et sont de plus en utilisées dans les réseaux de transmission optique (ceci pour répondre à des besoins de reconfiguration des réseaux de communications optiques).
   Les limites d'un tel procédé ne sont pas tant d'ordre technologique qu'économique. En effet, dès lors qu'une application requiert un grand nombre de sources accordables, se pose inévitablement le problème du coût. Or, de telles sources accordables sont technologiquement très pointues, coûteuses à fabriquer et à caractériser. En outre, dans le cas des diodes de type DBR, l'accord en longueur d'onde est réalisé en jouant sur trois paramètres différents (qui correspondent à trois courants à injecter dans trois sections différentes de la diode). Une caractérisation complète de la diode est nécessaire pour connaître le triplet de courants à appliquer pour faire fonctionner la diode à la longueur d'onde souhaitée. Ces points de fonctionnement sont mémorisés dans une carte électronique. Ceci explique leur coût d'utilisation relativement élevé et une gestion du fonctionnement en parallèle de N sources quelque peu compliquée (il faut caractériser et mémoriser les points de fonctionnements des N sources).
2) Les inventeurs étudient au laboratoire depuis quelques années des cavités laser dans lesquelles sont insérés des filtres dits "dynamiques". À la différence des filtres statiques, leur réponse fréquentielle n'est pas fixe et s'adapte à la structure de modes du laser. Ces filtres comportent un milieu holographique dynamique dans lequel la structure de modes du laser enregistre un hologramme qui va alors agir sur les pertes de ces modes. Ces pertes sont différentes pour les modes et conduisent, après un phénomène de compétition, à une réduction de leur nombre. L'hologramme s'adapte en permanence à la nouvelle structure de modes pour, dans certains cas, n'en sélectionner qu'un seul. L'insertion d'un cristal photoréfractif (qui joue le rôle de milieu holographique dynamique) conduit à une réduction d'un facteur 300 de la largeur du spectre d'un laser Ti :Saphir fonctionnant en régime pulsé et au fonctionnement en régime monomode d'un laser continu Nd :YVO₄. Ces lasers oscillent initialement, sans milieu holographique, en régime multimode. Il est à noter que dans le cas particulier du laser Nd :YVO₄, la cavité ne comporte aucun élément sélectif en fréquence, autre que l'hologramme qui s'inscrit dans le cristal photoréfractif. Des résultats identiques ont été obtenus dans une source à diode laser en cavité étendue. Le caractère dynamique du filtre lui permet de s'adapter au point de fonctionnement du laser. En effet, dans le cas d'un changement de point de fonctionnement du laser, le filtre s'adaptera à la nouvelle structure de modes et conservera une oscillation monomode. En revanche, en dehors de l'utilisation de tout autre filtre statique, il est impossible de prédire a priori la longueur d'onde à laquelle le laser va osciller après inscription de l'hologramme. Le seul événement prévisible est que le spectre du laser, initialement multimode, est rendu monomode après insertion du milieu holographique dans la cavité.
   En combinant dans la cavité un filtre statique et un filtre dynamique, il est par contre possible de fixer la longueur d'onde de fonctionnement du laser comme montré dans "S.F. Lyuksyutov and O.I. Yuschuk, "Spectral equalization and autosweeping effects in a pulsed dye laser with an intracavity photorefractive element", Applied Optics, vol. 31, pp. 1217-1220, 1992". Dans une première phase, le laser fonctionne en présence du réseau et du cristal dans lequel s'enregistre un hologramme. Il oscille alors simultanément à plusieurs longueurs d'onde. Puis, en faisant fonctionner le laser avec le seul cristal dans la cavité, le laser continue à osciller à ces mêmes longueurs d'onde pendant une durée courte de quelques minutes. Au bout de quelques minutes la longueur d'onde d'oscillation change.
   Dans le cas où la cavité ne présente pas d'élément sélectif en fréquence autre qu'un filtre holographique dynamique, comprenant par exemple un cristal photoréfractif, la limite de ce type de cavité provient de ce que la longueur d'onde à laquelle le laser oscille ne peut être prédit a priori.
3) Il existe une autre méthode, bien connue et étudiée depuis de nombreuses années, du contrôle du spectre d'un laser : l'injection optique. Elle consiste à disposer d'un laser dit "maître" dont le faisceau est injecté dans un laser dit "esclave" Sous certaines conditions, liées à la puissance du faisceau issu du laser maître et au désaccord entre la fréquence d'oscillation du laser maître et la fréquence d'un des modes résonnants dans la cavité du laser esclave, le laser esclave peut alors osciller à une longueur d'onde voisine, voire identique, à celle du laser maître.

Ces propriétés sont conservées tant que l'injection du faisceau issu du laser maître est effective. Dès que ce dernier disparaît, le laser esclave retrouve ses conditions de fonctionnement initiales.

Si l'on dispose dans ce schéma d'un laser "maître" accordable en longueur d'onde, il est possible de disposer d'un ou plusieurs lasers "esclave" accordables. En revanche, tous les lasers "esclave" fonctionneront à une même longueur d'onde (fixée par celle du laser "maître"). Il est impossible de configurer un des lasers "esclave" indépendamment des autres. Tous les lasers "esclave" sont dépendants les uns des autres.

La présente invention entend remédier aux inconvénients de l'art antérieur en offrant la possibilité de mémoriser la longueur d'onde (l'état) de fonctionnement du laser esclave injecté après coupure du faisceau de contrôle (d'injection) issu du laser maître.

De plus, comme le laser esclave intégrant un milieu holographique est capable de conserver la longueur d'onde programmée après coupure du faisceau d'injection, le laser maître est disponible pour programmer un second laser esclave. La programmation de ce second laser esclave peut se faire à une longueur d'onde différente de celle du premier laser programmé dans le cas où l'on dispose d'un laser maître accordable (programmable) en longueur d'onde. Ainsi, un seul laser maître, accordable en longueur d'onde, peut adresser (programmer) optiquement plusieurs (le nombre n'est a priori pas limité) lasers "esclave" intégrant un milieu holographique et ce, à des longueurs d'onde différentes et reprogrammables pour chaque laser.

À cet effet, la présente invention concerne, dans son acception la plus générale, un dispositif pour l'émission d'au moins un faisceau laser monomode accordable, comprenant un laser maître accordable excitant au moins un laser esclave, caractérisé en ce que la cavité dudit laser esclave comprend un milieu holographique dynamique.

Plus précisément, elle concerne un dispositif optique comprenant un laser maître accordable et dont tout ou partie du faisceau est injecté dans au moins un laser esclave, caractérisé en ce que la cavité dudit laser esclave comporte, en plus d'un milieu amplificateur, un milieu holographique dynamique formant un filtre spectral auto-adapté.

Le milieu holographique dynamique permet de maintenir l'oscillation du laser esclave à la longueur d'onde imposée par le laser maître lors de l'injection après arrêt de l'injection.

De préférence, le dispositif comporte un ou une pluralité de lasers "esclave" comportant chacun un milieu holographique dynamique.

Avantageusement, la cavité comporte un filtre large bande pour la compensation de la courbure de gain.

Selon un mode de mise en oeuvre particulièrement avantageux, ledit milieu holographique dynamique est positionné à l'intérieur de la cavité près du coupleur de sortie.

Selon un mode de réalisation préféré, ledit milieu holographique dynamique est un cristal photoréfractif.

De préférence, l'injection du faisceau provenant du laser maître est réalisée par la face de sortie du laser esclave, par l'intermédiaire d'un circulateur optique.

La présente invention se rapporte également à un équipement de test de composants optroniques comportant une pluralité de sources lumineuses caractérisé en ce que ladite source comprend un laser maître accordable et une pluralité de lasers "esclave" comprenant chacun un milieu holographique dynamique.

Enfin, la présente invention concerne également une source d'adressage optique pour former un peigne de longueurs d'onde caractérisé en ce que ladite source comprend un laser maître accordable et une pluralité de lasers "esclave" comprenant chacun un milieu holographique dynamique.

La présente invention associe les techniques basées sur l'injection optique et sur l'insertion dans la cavité laser d'un milieu holographique dynamique. L'injection optique force le laser à osciller à une longueur d'onde désirée et variable. Le milieu holographique permet au laser de conserver l'oscillation à cette même longueur d'onde en l'absence de l'injecteur. Ainsi les limites exposées pour chacune des deux techniques sont levées.

L'intérêt de l'invention prend tout son sens dans le cadre d'une application où l'on doit disposer de plusieurs sources laser accordables. Une première solution consiste à disposer de N sources accordables identiques et basées sur une technologie de cavité qui intègre un filtre statique. La source peut au besoin être compacte (technologie intégrée). Comme nous l'avons évoqué, ces sources sont très performantes mais coûteuses. Le coût d'une source est à multiplier par le nombre de sources. En outre, ces sources sont complexes et délicates à faire fonctionner. Dans le cas la présente invention, les N sources sont basées sur une technologie plus simple et surtout sont commandées par une seule source "maître" qui est une source accordable. Le coût de cette source est réparti sur l'ensemble des lasers "esclave". L'effort technologique est également réparti. Dans la limite des connaissances actuelles, les lasers "esclave" sont bien moins compliqués à faire fonctionner et à caractériser. Ils devraient représenter un moindre coût.

L'invention permet en particulier la programmation ou l'adressage optique de la longueur d'onde du laser.

Cet adressage peut se faire à distance. Le laser maître dans l'absolu peut être éloigné du laser esclave à commander. Il suffit d'une centaine de µW (autour de -10 dBm) de puissance de faisceau issu du laser maître pour perturber le laser esclave et pour que celui-ci mémorise la longueur d'onde adressée par le laser maître. Concrètement, il est envisageable de disposer d'un laser maître dans un central distant du noeud de plusieurs dizaines de kilomètres et qui télécommande optiquement la longueur d'onde du laser placé au niveau de ce noeud. Si décision est prise au niveau du central de changer la longueur d'onde allouée à ce noeud, elle est transmise au laser maître (donc à proximité) qui agit alors à distance sur le laser esclave. La transmission de la commande est optique et la nature du signal de commande est simple : un faisceau issu du laser maître dont la cohérence doit être transférée au laser esclave distant. Dans le cas de l'utilisation au niveau des noeuds de diodes accordables, la commande doit être électrique.

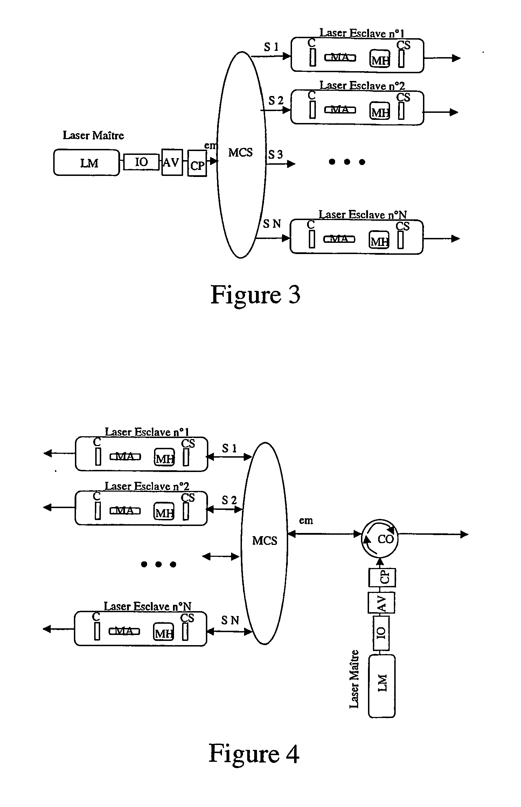

L'argument essentiel est sans doute illustré par les figures 3 et 4 où nous présentons des variantes quant à l'architecture possible entre un laser maître qui commande en longueur d'onde une matrice de N lasers "esclave". L'intérêt de cette architecture est le partage par N lasers "esclave" d'une seule source accordable. On peut imaginer que cette source est coûteuse à fabriquer et que les N lasers "esclave" puissent être identiques et basés sur une technologie moins coûteuse (il n'est pas nécessaire de faire appel à une technologie tout intégrée). Bien entendu l'argument sur le coût n'est que spéculatif et doit être précisé mais semble à première vue réaliste. L'effort technologique est mis sur le laser maître (source à diode laser accordable, diode laser DBR...) qui devra être notamment calibré (qualifié) en longueurs d'onde. Ceci justifie le coût élevé de ce type de sources. Pour les lasers "esclave", il est a priori inutile de les calibrer en longueurs d'onde, contrairement aux diodes laser DBR actuellement utilisées dans les noeuds des réseaux de télécommunications optiques.
- En parlant de coût, on pense forcément à une solution pour des réseaux proches de l'abonné où l'allocation en bande passante doit nécessairement être plus souple pour s'adapter au flux variable. En outre, ces lasers "esclave" semblent s'adapter facilement à la granularité optique (en termes de densité de porteuses) du réseau. Il est tout aussi possible de faire fonctionner un même laser dans un réseau DWDM ou WDM, avec des écarts entre longueurs d'onde de 0,4, 0,8, 1,6 nm ; voire plus.

On comprendra mieux l'invention à l'aide de la description, faite ci-après à titre purement explicatif, d'un mode de réalisation de l'invention, en référence aux figures annexées où :
- la figure 1 illustre un laser esclave contenant un milieu holographique dynamique (MH) soumis à l'injection optique d'un faisceau issu d'un laser maître (LM);
- la figure 2 illustre un second mode réalisation de l'invention qui diffère du mode de réalisation de la figure 1 par l'utilisation d'un circulateur optique (CO) ;
- la figure 3 illustre une matrice de lasers "esclave", chacun comprenant un milieu holographique dynamique (MH) et dont la longueur d'onde est fixée par injection optique du faisceau issu du laser maître à travers une matrice de commutation spatiale (MCS) qui sélectionne le ou les lasers "esclave" à programmer ;
- la figure 4 illustre une disposition schématique du quatrième mode de réalisation ;
- la figure 5 représente de façon schématique un montage d'injection optique ;
- la figure 6 illustre des spectres optiques du laser esclave programmés à l'aide du laser maître par
injection optique selon un peigne de longueurs d'onde quasi-périodique.

L'invention porte sur un laser, qualifié de " laser esclave", dont la cavité intègre un milieu holographique dynamique et dont la longueur d'onde est fixée par injection optique dans sa cavité d'un faisceau issu d'un second laser, qualifié de ''laser maître''. En régime d'injection, la structure de mode qui oscille dans la cavité du laser esclave enregistre un hologramme dans le milieu holographique dynamique. Cet hologramme diminue les pertes du ou des modes qui oscillent dans la cavité du laser esclave et par conséquent renforce leur fonctionnement. Après coupure du faisceau issu du laser maître, l'hologramme est entretenu par le mode qui oscille, et en retour, assure l'oscillation sur cet unique mode : le laser esclave conserve ainsi la longueur d'onde imposée par le laser maître. Ainsi, la longueur d'onde du laser esclave est fixée par injection optique d'un faisceau issu d'un laser maître et mémorisée par le laser esclave après extinction du faisceau issu du laser maître.

### Premier mode de réalisation :

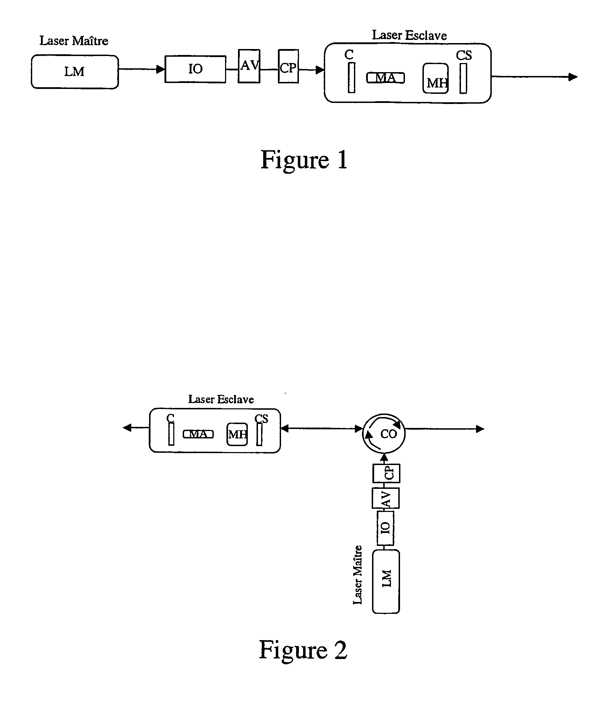

Le laser esclave (voir Figure 1) est composé d'un milieu amplificateur (MA) et d'une cavité (linéaire) formée par au moins deux miroirs (C et CS) à l'intérieur de laquelle est inséré un milieu holographique dynamique (MH). Le faisceau issu du laser maître (LM) est injecté dans la cavité du laser esclave, soit directement, soit en ayant au préalable traversé un isolateur optique (IO) qui protège le laser maître contre des éclairements parasites extérieurs, un atténuateur variable (AV) qui permet de régler la puissance du faisceau issu du laser maître à injecter dans le laser esclave, et un contrôleur de polarisation (CP) qui permet de faire coïncider l'état de polarisation du faisceau issu du laser maître avec celui issu du laser esclave. Les composants référencés IO, AV et CP sont optionnels. Les liaisons optiques qui figurent entre les différents éléments (flèches noires) se font soit en espace libre, soit dans des guides d'onde optique (exemple, des fibres optiques).

D'autres agencements sont possibles entre le laser maître et le laser esclave qui comprend un milieu holographique dynamique et ce dans le but d'injecter tout ou partie du faisceau issu du laser maître dans la cavité du laser esclave. Des exemples sont décrits ci-dessous.

### Second mode de réalisation :

Une variante (Figure 2) consiste à réaliser l'injection du faisceau issu du laser maître dans la cavité du laser esclave à travers un circulateur optique (CO). Le faisceau issu du laser maître pénètre dans le CO, il est alors dirigé directement dans la cavité du laser esclave (en incidence sur le CS). Le faisceau laser produit par le laser esclave peut sortir à travers le coupleur C ou bien à travers le coupleur de sortie (CS). Le faisceau émis à travers CS est incident sur le CO et est dirigé vers l'extérieur et non vers le laser maître. L'utilisation du CO est intéressante lorsque le coupleur C du laser esclave est un miroir hautement réfléchissant. En outre, le CO isole le laser maître contre les radiations lumineuses émises par le laser esclave et permet de s'affranchir de l'isolateur optique (IO).

### Troisième mode de réalisation :

Comme l'injection optique du faisceau issu du laser maître n'est que temporaire (le temps nécessaire à l'hologramme de s'inscrire), le faisceau peut alors être utilisé pour l'injection d'un autre laser esclave. Ainsi, la géométrie de cavité proposée pour le laser esclave offre la possibilité de contrôler à l'aide d'un seul laser maître une série de lasers "esclave". Il suffit de déplacer le faisceau issu du laser maître vers le laser esclave à contrôler. Cette utilisation d'un seul laser maître pour contrôler N lasers "esclave" est d'un très grand intérêt dès que le laser maître est accordable en longueur d'onde. Chaque laser esclave est alors programmable (adressable) à des longueurs d'onde différentes. Cet adressage est optique et reconfigurable. Pour changer la longueur d'onde de fonctionnement d'un laser esclave, il suffit de réitérer le processus d'injection en ayant au préalable accordé le laser maître sur une nouvelle longueur d'onde. On dispose ainsi d'une matrice de lasers à adressage optique de la longueur d'onde reconfigurable.

La configuration de cette variante est présentée dans la figure 3 où sont disposés N (N>1) lasers "esclave", identiques au laser esclave de la figure 1 reliés au laser maître par une matrice de commutation spatiale. Cette matrice a pour seule fonction de sélectionner un chemin optique pour relier le faisceau (em) issu du laser maître vers un ou plusieurs lasers "esclave" qui sont reliés aux différentes sorties S2, S2, ... SN de la MCS.

### Quatrième mode de réalisation :

La figure 4 décrit une configuration de programmation d'une matrice de lasers "esclave", similaire à la variante 2, au détail près du circulateur optique (CO) inséré entre le laser maître et la matrice de commutation spatiale (MCS).

### Exemple de démonstration de l'invention :

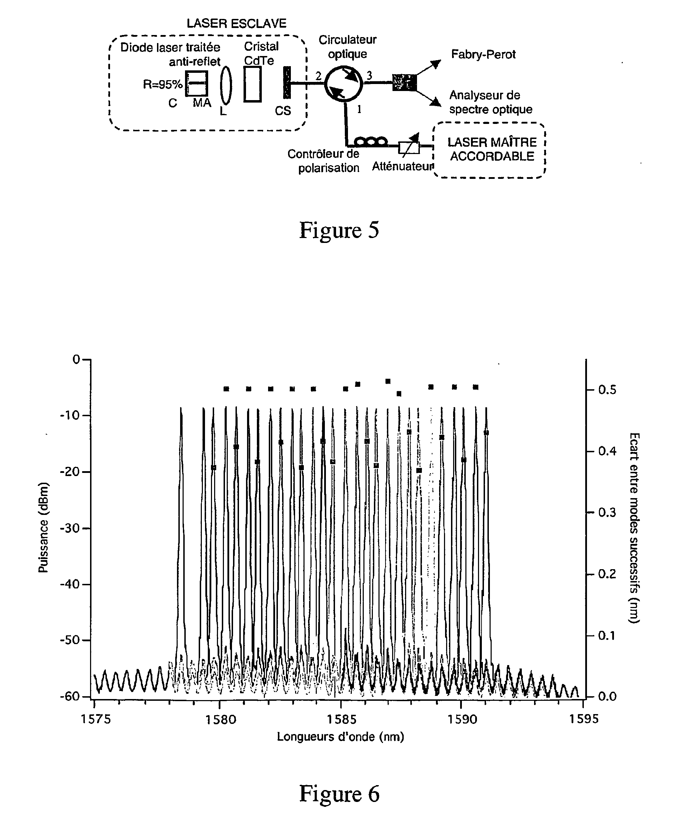

La figure 5 présente un mode de réalisation avantageux qui a servi à faire une démonstration expérimentale de l'invention. Le laser esclave est constitué d'un milieu amplificateur MA (diode semi-conductrice) dont l'une des faces C est traitée haute réflexion et l'autre traitée antireflet. Le faisceau issu de cette face est rendu parallèle par la lentille de collimation L. La cavité esclave est close par le coupleur de sortie CS (miroir semi-réfléchissant). Un cristal photoréfractif de CdTe est employé comme milieu holographique dynamique. Il est inséré dans la cavité entre CS et L. Il est coupé de sorte que les deux faisceaux contrepropageants de la cavité y inscrivent un hologramme par réflexion. Cet hologramme et le coupleur de sortie CS constituent un filtre spectral (Fabry-Perot en réflexion) automatiquement adapté au mode qui oscille. Si le cristal est positionné dans le bon sens, ce filtre spectral présente un minimum de pertes pour la longueur d'onde du mode qui l'a inscrit, mode qui est celui qui oscille.

Le laser maître est une source à diode laser monomode, accordable de 1480 à 1600 nm. Tout le montage est fibré. La sortie du laser maître est reliée à la sortie de la cavité du laser esclave par l'intermédiaire d'un circulateur optique. En sortie du laser maître, on dispose d'un atténuateur variable et d'un contrôleur de polarisation. L'analyse des propriétés spectrales du laser esclave est faite grâce au Fabry-Perot et à un analyseur de spectre optique précités. Ces appareils sont reliés à un coupleur 50/50 ; lui-même relié à la sortie 3 du circulateur.

Grâce à ce montage, l'effet de mémorisation de la longueur d'onde par le laser esclave après injection optique du faisceau issu du laser maître a été vérifié.

Dans le domaine des télécommunications optiques, les sources laser génèrent des porteuses optiques dont les positions en longueur d'onde sont normalisées et espacées de 0,8 ou 0,4 nm. Les porteuses doivent être réparties sur une grille périodique définie par la norme ITU.

Le laser esclave est accordé par l'intermédiaire du laser maître, selon une pseudo-grille ITU. Le laser esclave oscille initialement à 1584,671 nm. Le laser maître est successivement accordé selon une grille de longueurs d'onde comprises en 1578,493 nm et 1591,541 nm, avec un espacement entre les valeurs compris entre 0,4 et 0,5 nm. Pour chaque longueur d'onde, le faisceau issu du laser maître est injecté dans le laser esclave (celui-ci oscillant préalablement à 1584,671 nm). La longueur d'onde du laser maître est alors finement ajustée de sorte que l'on observe clairement un déplacement de la longueur d'onde du laser esclave vers celle du maître. Le faisceau issu du maître est alors coupé, et la longueur d'onde du laser esclave est mesurée grossièrement à l'analyseur de spectre optique (précision ± 0,001 nm). Les spectres successifs mesurés en sortie du laser esclave, après injection du laser maître, sont regroupés sur un même graphe dans la figure 6. Il est ainsi possible de programmer le fonctionnement de cette source à diode laser esclave sur 27 longueurs d'onde différentes autour de 1584 nm. L'écart en longueur d'onde entre deux porteuses successives est représenté par les carrés. Certes, le peigne n'est pas très périodique (un peigne périodique est réalisable). Mais l'écart entre les porteuses reste compris entre 0,4 et 0,5 nm. Avec cette même configuration, on aurait pu programmer un peigne de 0,8 nm d'écartement, voire 1,6 nm.

Les tests reportés démontrent d'une part la faisabilité de l'invention et d'autre part valident son utilisation dans le domaine des télécommunications optiques.

L'invention est décrite dans ce qui précède à titre d'exemple. Il est entendu que l'homme du métier est à même de réaliser différentes variantes de l'invention sans pour autant sortir du cadre du brevet tel que définit par les revendications.

## Revendications

1. Dispositif optique comprenant un laser maître accordable (LM) et dont tout ou partie du faisceau est injecté dans au moins un laser esclave, **caractérisé en ce que** la cavité dudit laser esclave comporte, en plus d'un milieu amplificateur (MA), un milieu holographique (MH) dynamique formant un filtre spectral auto-adapté et qui permet de maintenir l'oscillation du laser esclave à la longueur d'onde imposée par le laser maître lors de l'injection après arrêt de l'injection.

2. Dispositif selon la revendication 1, **caractérisé en ce qu'**il comporte une pluralité de lasers "esclave" comportant chacun un milieu holographique dynamique.

3. Dispositif selon la revendication 1 ou 2, **caractérisé en ce que** la cavité du ou des lasers "esclave" comporte un filtre spectral fixe dont la réponse spectrale compense la courbure de gain du milieu à gain du milieu amplificateur présent dans cette même cavité.

4. Dispositif selon l'une quelconque des revendications précédentes, **caractérisé en ce que** ledit milieu holographique dynamique est positionné à l'intérieur de la cavité près du coupleur de sortie.

5. Dispositif selon l'une quelconque des revendications précédentes, **caractérisé en ce que** ledit milieu holographique dynamique est un cristal photoréfractif.

6. Dispositif selon l'une quelconque des revendications précédentes, **caractérisé en ce que** l'injection du faisceau provenant du laser maître est réalisée par la face de sortie du laser esclave, par l'intermédiaire composant permettant de relier temporairement ou de façon définitive ledit laser maître à un ou plusieurs lasers "esclave".

7. Dispositif selon la revendication 6, **caractérisé en ce que** ledit composant est un circulateur optique.

8. Equipement de test comportant une pluralité de sources lumineuses formant un peigne de longueurs d'onde, **caractérisé en ce que** chaque source est un dispositif optique selon l'une des revendications 1 à 7 précédentes comportant une pluralité de lasers "esclaves" comprenant chacun un milieu holographique dynamique.

9. Source d'adressage optique pour former un peigne de longueurs d'onde, **caractérisé en ce que** la source est un dispositif optique selon l'une quelconque des revendications 1 à 7 précédentes comportant une pluralité de lasers "esclaves" comprenant chacun un milieu holographique dynamique.

## Claims

1. Optical device comprising a tuneable master laser (LM) all or part of the beam of which is injected into at least one slave laser, **characterised in that** the cavity of said slave laser includes, in addition to an amplifier medium (MA), a dynamic holographic medium (MH) forming a self-adapted spectral filter and that makes it possible to maintain the oscillation of the slave laser at the wavelength imposed by the master laser during injection after stopping injection.

2. Device according to claim 1, **characterised in that** it includes a plurality of "slave" lasers each including a dynamic holographic medium.

3. Device according to claim 1 or 2, **characterised in that** the cavity of the "slave" laser or lasers includes a fixed spectral filter the spectral response of which compensates the gain curvature of the gain medium of the amplifier medium present in the same cavity.

4. Device according to any of the preceding claims, **characterised in that** said dynamic holographic medium is positioned in the interior of the cavity near the output coupler.

5. Device according to any of the preceding claims, **characterised in that** said dynamic holographic medium is a photorefractive crystal.

6. Device according to any of the preceding claims, **characterised in that** the injection of the beam from the master laser is effected via the output face of the slave laser, via a component making it possible to connect said master laser to one or more "slave" lasers temporarily or permanently.

7. Device according to claim 6, **characterised in that** said component is an optical circulator.

8. Test equipment including a plurality of light sources forming a comb of wavelengths, **characterised in that** each source is an optical device according to any of claims 1 to 7 above including a plurality of "slave" lasers each comprising a dynamic holographic medium.

9. Optical addressing source forming a comb of wavelengths, **characterised in that** the source is an optical device according to any of claims 1 to 7 above including a plurality of "slave" lasers each comprising a dynamic holographic medium.

## Patentansprüche

1. Optische Vorrichtung, umfassend einen abstimmbaren Master-Laser (LM), dessen Strahl ganz oder teilweise in mindestens einen Slave-Laser eingekoppelt wird, **dadurch gekennzeichnet, dass** der Hohlraum des Slave-Lasers zusätzlich zu einem Verstärkermedium (MA) ein dynamisches holografisches Medium (MH) umfasst, das ein selbstangepasstes Spektralfilter bildet, und das es ermöglicht, die Schwingung des Slave-Lasers auf der von dem Master-Laser vorgeschriebenen Wellenlänge bei der Einkopplung nach Unterbrechung der Einkopplung aufrecht zu erhalten.

2. Vorrichtung nach Anspruch 1, **dadurch gekennzeichnet, dass** sie eine Vielzahl von "Slave"-Lasern umfasst, die jeweils ein dynamisches holografisches Medium umfassen.

3. Vorrichtung nach Anspruch 1 oder 2, **dadurch gekennzeichnet, dass** der Hohlraum des oder der "Slave"-Laser(s) ein festes Spektralfilter umfasst, dessen Spektralantwort die Verstärkungscharakteristik des Verstärkungsmediums des in eben diesem Hohlraum vorliegenden Verstärkermediums ausgleicht.

4. Vorrichtung nach einem der vorhergehenden Ansprüche, **dadurch gekennzeichnet, dass** das dynamische holografische Medium im Innern des Hohlraums neben dem Ausgangskoppler positioniert ist.

5. Vorrichtung nach einem der vorhergehenden Ansprüche, **dadurch gekennzeichnet, dass** das dynamische holografische Medium ein fotorefraktiver Kristall ist.

6. Vorrichtung nach einem der vorhergehenden Ansprüche, **dadurch gekennzeichnet, dass** das Einkoppeln des Strahls, der aus dem Master-Laser stammt, durch die Ausgangsseite des Slave-Lasers über ein Bauteil, das es ermöglicht, den Master-Laser vorübergehend oder definitiv mit einem oder mehreren "Slave"-Lasern zu verbinden, erfolgt.

7. Vorrichtung nach Anspruch 6, **dadurch gekennzeichnet, dass** das Bauteil ein optischer Zirkulator ist.

8. Testeinrichtung, umfassend eine Vielzahl von Lichtquellen, die einen Wellenlängenkamm bilden, **dadurch gekennzeichnet, dass** jede Quelle eine optische Vorrichtung nach einem der vorhergehenden Ansprüche 1 bis 7 ist, die eine Vielzahl von "Slave"-Lasern umfasst, die jeweils ein dynamisches holografisches Medium umfassen.

9. Optische Adressierquelle zum Bilden eines Wellenlängenkamms, **dadurch gekennzeichnet, dass** die Quelle eine optische Vorrichtung nach einem der vorhergehenden Ansprüche 1 bis 7 ist, die eine Vielzahl von "Slave"-Lasern umfasst, die jeweils ein dynamisches holografisches Medium umfassen.
